(19) Europäisches Patentamt
European Patent Office
Office européen des brevets

(11) **EP 2 103 952 B1**

(12) **EUROPÄISCHE PATENTSCHRIFT**

(45) Veröffentlichungstag und Bekanntmachung des Hinweises auf die Patenterteilung:
**03.07.2013 Patentblatt 2013/27**

(51) Int Cl.:
*G01R 33/561* (2006.01)      *G01R 33/483* (2006.01)
*G01R 33/54* (2006.01)

(21) Anmeldenummer: **09003585.8**

(22) Anmeldetag: **12.03.2009**

(54) **MR-Verfahren zur selektiven Anregung mittels Großwinkel- und Kleinwinkel-HF-Pulse**

MR method for selective excitation using HF pulses with both large and small flip angles

Procédé RMN destiné à l'excitation sélective via des impulsions à haute fréquence avec des angles de bascule larges et faibles

(84) Benannte Vertragsstaaten:
**AT BE BG CH CY CZ DK EE ES FI FR GB GR HR HU IE IS IT LI LT LU LV MC MK MT NL NO PL PT RO SE SI SK TR**

(30) Priorität: **19.03.2008 DE 102008015054**

(43) Veröffentlichungstag der Anmeldung:
**23.09.2009 Patentblatt 2009/39**

(73) Patentinhaber: **Universitätsklinikum Freiburg**
**79106 Freiburg (DE)**

(72) Erfinder:
• **Haas, Martin**
**79106 Freiburg (DE)**
• **Zaitsev, Maxim**
**79117 Freiburg (DE)**
• **Hennig, Jürgen**
**79100 Freiburg (DE)**

(74) Vertreter: **Kohler Schmid Möbus**
**Patentanwälte**
**Ruppmannstraße 27**
**70565 Stuttgart (DE)**

(56) Entgegenhaltungen:
• HAAS M ET AL: "Two-Step Small Transverse Magnetization Method for the Design of 180 DEG Spatially Selective RF pulses" INTERNATIONAL SOCIETY FOR MAGNETIC RESONANCE IN MEDICINE.SCIENTIFIC MEETING AND EXHIBITION. PROCEEDINGS, INTERNATIONAL SOCIETY FOR MAGNETIC RESONANCE IN MEDICINE, US, 3. Mai 2008 (2008-05-03), Seite 1319, XP007908868 ISSN: 1524-6965

• XU DAN ET AL: "Designing multichannel, multidimensional, arbitrary flip angle RF pulses using an optimal control approach" MAGNETIC RESONANCE IN MEDICINE, ACADEMIC PRESS, DULUTH, MN, US, Bd. 59, Nr. 3, 1. März 2008 (2008-03-01), Seiten 547-560, XP007908761 ISSN: 0740-3194
• KATSCHER U ET AL: "TRANSMIT SENSE" MAGNETIC RESONANCE IN MEDICINE, ACADEMIC PRESS, DULUTH, MN, US, Bd. 49, Nr. 1, 1. Januar 2003 (2003-01-01), Seiten 144-150, XP009016770 ISSN: 0740-3194
• TONY ST OCKER ET AL: "HPC Simulation of Magnetic Resonance Imaging" PARALLEL COMPUTING: ARCHITECTURES, ALGORITHMS AND APPLICATIONS (IN: NIC SERIE), IOP PRESS, Bd. 38, 1. Januar 2008 (2008-01-01), Seiten 155-164, XP007908894 ISBN: 978-1-58603-796-3
• CHUN-YU YIP ET AL: "Joint Design of Trajectory and RF Pulses for Parallel Excitation" MAGNETIC RESONANCE IN MEDICINE, ACADEMIC PRESS, DULUTH, MN, US, Bd. 58, 1. Januar 2007 (2007-01-01), Seiten 598-604, XP007902913 ISSN: 0740-3194
• ULLMANN P ET AL: "Experimental Analysis of Parallel Excitation Using Dedicated Coil Setups and Simultaneous RF Transmission on Multiple Channels" MAGNETIC RESONANCE IN MEDICINE, ACADEMIC PRESS, DULUTH, MN, US, Bd. 54, 1. Januar 2005 (2005-01-01), Seiten 994-1001, XP002494701 ISSN: 0740-3194 [gefunden am 2005-09-09]
• ZHU Y: "Parallel Excitation With an Array of Transmit Coils" MAGNETIC RESONANCE IN MEDICINE, ACADEMIC PRESS, DULUTH, MN, US, Bd. 51, 1. Januar 2004 (2004-01-01), Seiten 775-784, XP002420793 ISSN: 0740-3194

**Beschreibung**

Die Erfindung betrifft ein Magnetresonanz-Verfahren zur Anwendung eines Hochfrequenzpulses in einem Probenvolumen für eine räumlich und frequenzselektive oder mehrdimensional räumlich selektive Anregung eines Ensembles von Kernspins mit einer Ausgangsmagnetisierungsverteilung in einem entlang einer z-Achse ausgerichteten Hauptmagnetfeld, wobei eine Spinmagnetisierung mit einer vorgegebenen Zielmagnetisierungsverteilung erzeugt wird, und für eine entsprechend selektive Refokussierung der Spinmagnetisierung, wobei der Hochfrequenzpuls aus einer Sequenz mehrerer Teilpulse zusammengesetzt ist.

Ein solches Verfahren ist aus [4] bekannt.

Die Verwendung von durch Hochfrequenz(=HF)spulen erzeugten HF Pulsen in Verbindung mit Magnetfeldgradienten ist das Standardverfahren zur Schichtselektion in der Magnetresonanz-Bildgebung. Hierbei sind die Gradienten zeitlich konstant und die HF-Pulse haben eine sinc(t)-ähnliche Einhüllende. Dieses Verfahren kann als Anregung entlang einer k-Raum-Zeile aufgefasst werden.

Für mehrdimensional räumliche Selektion muss daher der k-Raum bei der Anregung in der entsprechenden Dimensionalität durchlaufen werden, was aufgrund von Slew-Beschränkungen (Hardware und Nervenstimulation) bisher in praktikabler Zeit (<20ms) sehr schwierig war. Mit dem Aufkommen paralleler Anregungstechniken kann die Pulsdauer bei der Anregung jedoch durch Verwendung mehrerer, räumlich inhomogener Sendespulen verkürzt werden und die räumlich selektive Anregung und Refokussierung in 2 und 3 Dimensionen oder auch in Kombination mit einer Frequenzdimension kommen in erreichbare Nähe. In [1] werden die ersten experimentellen Realisierungen demonstriert und zeigen den Stand der Technik im Kleinwinkelbereich auf.

Die räumlich selektive Anregung in mehreren Dimensionen zielt auf Anwendungen wie zum Beispiel "inner volume imaging", "outer volume saturation" oder Spektroskopie, bei der eine beliebig (anatomisch) geformte Region der Probe/des Probanden (Zielmuster) ausgewählt und gezielt angeregt oder refokussiert werden kann. Für diese Art der selektiven Anregung müssen daher HF Pulse für jedes Zielmuster spezifisch berechnet werden. Darüber hinaus sind die Sendeprofile der HF-Spulen patientenspezifisch, daher hängen die HF-Pulse außerdem von den gemessenen Sendeprofilen ab, die erst zur Verfügung stehen, wenn sich der Patient schon im Tomographen befindet. Ein sehr wichtiges Kriterium für die Anwendbarkeit der anatomisch angepassten räumlich selektiven Anregung ist daher außer der Genauigkeit des Anregungsmusters die Dauer, die für die Berechnung der HF Pulse benötigt wird.

Die Bloch'schen Gleichungen beschreiben die Zeitentwicklung einer Spinmagnetisierungsverteilung $\mathbf{M}$ in den Feldern $B_0$ (Hauptmagnetfeld), $\mathbf{B}_1$ (Hochfrequenzfeld) und Magnetfeldgradienten $\mathbf{G}$ wie folgt (fett gedruckte Buchstaben stehen für vektorielle Größen):

$$\frac{\partial}{\partial t}\mathbf{M} = \begin{pmatrix} 0 & \Delta\omega & -\gamma B_{1,x} \\ -\Delta\omega & 0 & \gamma B_{1,y} \\ \gamma B_{1,x} & -\gamma B_{1,y} & 0 \end{pmatrix}\mathbf{M}, \tag{1}$$

wobei $\mathbf{M}$, $\mathbf{B}_1$ und $\Delta\omega$ orts- und zeitabhängig sind. Es gilt für einen Isochromaten: $\Delta\omega(t,\mathbf{r})=\gamma[\mathbf{r}\cdot\mathbf{G}(t)-\Delta B_0(\mathbf{r})]$, wobei der räumlich variierende Offresonanzterm $\Delta B_0(\mathbf{r})$ Inhomogenitäten des Hauptmagnetfeldes beschreibt. Hierbei sind T1- und T2-Relaxation vernachlässigt.

Die Bloch'schen Gleichungen in der Form (1) werden für mehrdimensional selektive Anregung als ein diskretisiertes Differentialgleichungssystem betrachtet, mit $N_s$ (Zahl der Punkte, an denen die Zielmagnetisierungsverteilung vorgegeben ist (Stützstellen)) Vektorgleichungen, und mit $N_c$ (Zahl der HF-Spulen) mal $N_t$ (Zahl der Zeitschritte) Freiheitsgraden zur Bestimmung der HF Pulse $I_l(t)$, die mit dem $\mathbf{B}_1$-Feld über die Sendeprofile der Spulen verknüpft sind.

Es gibt in der Literatur zwei Hauptansätze zur Lösung dieses Gleichungssystems:

1. "Optimal Control" [2,3], welches eine hohe Genauigkeit des Anregungsmusters liefert. Dieser Ansatz basiert auf der Lösung des Gleichungssytems (1) mit Hilfe von Methoden der Variationsrechnung, und erfordert pro HF-Optimierungsschritt (Iteration) eine vollständige Vorwärtslösung (Integration) der Bloch'schen Gleichungen, um den Anregungsfehler zu bestimmen und eine vollständige Rückwärtsintegration, um den um einen Schritt optimierten HF-Puls zu erhalten. Dieses Verfahren ist genau, aber mit typischen Rechenzeiten von bis zu einer Viertelstunde für eine sinnvolle Auflösung auf aktuellen Computern sehr zeit- und rechenintensiv. Es eignet sich daher nicht für den Einsatz in der klinischen Routine, in der die schnellste Methode bei gegebener Genauigkeit gewählt werden muss.

2. "Transmit SENSE" [1,4,5] (in der "small tip angle approximation"), welches auf einer Näherung der Bloch'schen Gleichungen für kleine Flipwinkel beruht. Mit dieser Näherung reduziert sich die Lösung der Bloch'schen Gleichungen auf das Lösen einer linearen Gleichung in $I_l$ (HF-Amplitude und Phase der I-ten Spule) für die Transversalmagnetisierung $M_t$:

$$M_t(\mathbf{r}) = i\gamma M_0(\mathbf{r})\int_0^T dt \sum_l S_l(\mathbf{r})I_l(t)\exp[i(\mathbf{k}(t)\cdot\mathbf{r}+\Delta\omega_0(\mathbf{r})(T-t))].\qquad(2)$$

Hierbei sind $S_l$ die Sendeprofile der HF-Spulen, $T$ die Gesamtdauer des HF Pulses, $M_0$ die Magnetisierung in z-Richtung zu Beginn des Pulses ($t=0$), k(t) die k-Raum-Trajektorie, die sich aus dem Gradientenverlauf G(t) ergibt und $\Delta\omega_0(r)$ die Offresonanz, die sich aus der Inhomogenität des $B_0$-Feldes ergibt. Die Sendeprofile, die Transversalmagnetisierung und die HF sind nach Konvention komplex, die x-Komponenten werden jeweils durch den Realteil und die y-Komponenten durch den Imaginärteil dargestellt.

Die Linearität dieser verbleibenden Aufgabe und die Tatsache, dass die Gleichungen für die z-Komponenten der Magnetisierung entkoppeln, ermöglichen eine verhältnismäßig einfache und schnelle Berechnung der HF-Pulse. Die inhärente Kleinwinkelnäherung schließt jedoch die alleinige Anwendung dieses Verfahrens der Pulsberechnung für große Flipwinkel >15° aus, die für effiziente Anregung der Spinmagnetisierung und für alle spinechobasierten Sequenzen unerlässlich sind.

Aufgabe der vorliegenden Erfindung ist es, ein Verfahren der in der Einleitung beschriebenen Art so zu verbessern, dass die oben diskutierten Nachteile vermieden werden können.

Erfindungsgemäß wird diese Aufgabe auf wirkungsvolle Art und Weise durch ein Verfahren gemäß Anspruch 1 gelöst. Bei dem erfindungsgemäßen Verfahren wird der Hochfrequenzpuls als eine Sequenz von Teilpulsen unabhängiger Dauern, Gradientenverläufen sowie räumlicher und/oder spektraler Auflösung angewendet, umfassend

- einen oder mehrere Großwinkel-HF-Pulse =GWP mit Flipwinkeln größer oder ungefähr gleich 15°, die eine grobe Magnetisierungsverteilung erzeugen, die die Zielmagnetisierungsverteilung oder eine gewünschte Magnetisierungsverteilungsänderung mit einer mittleren Abweichung kleiner oder ungefähr gleich 15° annähert, wobei die tatsächliche Auswirkung der GWP auf die Verteilung der Spinmagnetisierung vor der Anwendung des Hochfrequenzpulses durch Integration der Bloch-Gleichungen ohne Kleinwinkeinäherung berechnet wird, und
- einen oder mehrere Kleinwinkel-HF-Pulse =KWP mit Flipwinkeln kleiner oder ungefähr gleich 15°, die eine Verringerung des Unterschieds zwischen der Zielmagnetisierungsverteilung und der durch die GWP erzeugten groben Magnetisierungsverteilung bewirken.

Der anregende HF-Puls kann im Ein- oder Mehrkanalsendebetrieb mittels HF-Spulen mit einem homogenen oder inhomogenen Sendeprofil erzeugt werden und ist wie oben beschrieben aus einer Sequenz mehrerer HF-Pulse zusammengesetzt. Die Großwinkel-HF-Pulse erzeugen die gewünschte Zielmagnetisierungsverteilung oder die gewünschte Magnetisierungsänderung nur grob (mit mittleren Abweichungen $\lesssim 15°$), während die Kleinwinkel-HF-Pulse eine Verringerung des Unterschieds zwischen der Zielmagnetisierungsverteilung und der durch die Großwinkel-HF-Pulse bedingten groben Magnetisierungsverteilung bewirken. Unter der Zielmagnetisierungsverteilung wird dabei die Verteilung der Spinmagnetisierung innerhalb eines Zielmusters verstanden, die durch Anwendung des HF-Pulses erzeugt werden soll oder in die die Ausgangsmagnetisierungsverteilung durch Anwendung des HF-Pulses überführt werden soll. Die Reihenfolge der GWP und der KWP ist durch ihre beschriebene Funktion noch nicht festgelegt, insbesondere kann ein KWP die grobe Magnetisierungsverteilung, die durch die alleinige Anwendung eines GWP bedingt wäre, im Voraus korrigieren.

Bei dem erfindungsgemäßen Verfahren werden zunächst die Bloch'schen Gleichungen ohne Kleinwinkelnäherung integriert um die exakte Verteilung der Magnetisierung zu berechnen, die durch die Großwinkel-HF-Pulse bewirkt wird. Darüber hinaus sieht das erfindungsgemäße Verfahren vor, dass die Kleinwinkel-HF-Pulse in der Näherung kleiner transversaler Magnetisierung (STM) schnell und genau berechnet werden.

Durch den Umstand, dass das Verfahren die Integration der Bloch'schen Gleichungen beinhaltet und die Berechnung der KWP im gültigen Bereich der STM-Näherung stattfindet, kann die Genauigkeit der Methode sichergestellt werden, die so einer alleinigen Verwendung der Kleinwinkelnäherung überlegen ist.

Derselbe Umstand gestattet weiterhin eine schnelle Berechnung, da die Bloch-Integration nur ein einziges Mal (bzw. so viele Male, wie GWP in der Sequenz vorhanden sind) durchgeführt werden muss, und nicht für eine größere Anzahl von Iterationen jeweils zweimal, wie in der "Optimal Control".

Vorzugsweise werden die KWP durch Lösung der Bloch'schen Gleichungen in der Näherung kleiner transversaler Magnetisierung, d.h. mit Komponenten senkrecht zur z-Achse, die deutlich kleiner sind als die Komponente parallel zur z-Achse ("small transverse magnetization"=STM) bestimmt, wobei die Näherung für ein Ensemble von Kernspins gültig ist, das gleichzeitig Magnetisierungsvektoren mit Winkeln nahe bei 0° und nahe bei 180° bezogen auf die +z-Achse enthält. Die z-Achse wird hierbei durch die Richtung des Hauptmagnetfeldes eines MR-Magneten definiert, der für das Verfahren verwendet wird.

Die bei dieser Variante des erfindungsgemäßen Verfahrens verwendete STM-Näherung kann für ein Ensemble von Kernspins verwendet werden, in dem ein Teil der Magnetisierungsvektoren um $\leqslant$ 15° von der +z-Richtung (0°) und der andere Teil gleichzeitig um $\leqslant$ 15° von der -z-Richtung (180°) abweichen können, wobei ein zusätzlicher Freiheitsgrad gegenüber dem herkömmlichen Kleinwinkelverfahren gewonnen werden kann, insbesondere in der Wahl der Reihenfolge der KWP und GWP. Hierdurch können die Kleinwinkel-Teilpulse in der Näherung kleiner transversaler Magnetisierung (STM) schnell und genau berechnet werden.

Erfindungsgemäß werden die GWP durch Erhöhung der Amplitude von solchen HF-Pulsen erzeugt werden, die in STM-Näherung oder Kleinwinkelnäherung berechnet, da dies eine schnelle Berechnung der GWP ermöglicht, im Gegensatz zur Verwendung des herkömmlichen Verfahrens "Optimal Control".

Bei einer vorteilhaften Variante des erfindungsgemäßen Verfahrens wird die Spinmagnetisierung aus einer Ausgangsmagnetisierungsverteilung, bei der die Magnetisierungsvektoren in Richtung der z-Achse ausgerichtet sind, in die Zielmagnetisierungsverteilung mittels eines KWP und eines folgenden GWP überführt, indem die Bloch-Gleichungen von der Zielmagnetisierungsverteilung ausgehend rückwärts integriert und der Unterschied zwischen der so errechneten Magnetisierungsverteilung und der Ausgangsmagnetisierungsverteilung als eine neue zu erzeugende Zielmagnetisierungsverteilung für den KWP gesetzt wird. Die Ausgangsmagnetisierungsverteilung stellt die Magnetisierungsverteilung des Ensembles von Kernspins vor Anwendung des HF-Pulses dar. Der Vorteil einer Sequenz KWP-GWP besteht darin, dass die Magnetisierungsvektoren der Zielmagnetisierungsverteilung im Gegensatz zu einer Sequenz GWP-KWP beliebige Winkel zur +z-Achse bilden dürfen.

Bei einer anderen erfindungsgemäßen Variante wird die Spinmagnetisierung von einer Ausgangsmagnetisierungsverteilung in eine Zielmagnetisierungsverteilung, bei der die Magnetisierungsvektoren in Richtung der z-Achse ausgerichtet sind, mittels eines GWP und eines folgenden KWP überführt, indem die Bloch-Gleichungen von der Ausgangsmagnetisierungsverteilung ausgehend vorwärts integriert werden und der Unterschied zwischen der Zielmagnetisierungsverteilung und der so errechneten Magnetisierungsverteilung als eine neue zu erzeugende Zielmagnetisierungsverteilung für den KWP gesetzt wird. Der Vorteil dieses Verfahrens liegt in der Wiederverwendung von transversalen Komponenten der Magnetisierungsverteilung für eine folgende neue Anregung.

Bei einer weiteren vorteilhaften Variante des erfindungsgemäßen Verfahrens wird die Spinmagnetisierung um 180° aus einer Ausgangsmagnetisierungsverteilung, bei der die Magnetisierungsvektoren in Richtung der z-Achse ausgerichtet sind, rotiert. Eine selektive Rotation um 180° ist besonders vorteilhaft bei der Anwendung Spinechobasierter Bildgebungsverfahren und Kontrastvorbereitung durch Inversion der Spinmagnetisierung. Durch diese Variante des erfindungsgemäßen Verfahrens können Spinechobasierte Bildgebungsverfahren, "Inversion Recovery" und ähnliche Methoden in der entsprechenden Selektivität (räumlich und frequenzselektiv oder mehrdimensional räumlich selektiv) durchgeführt werden.

Vorzugsweise erfolgt hierbei die Rotation der Ausgangsmagnetisierungsverteilung mittels eines KWP und eines folgenden GWP, indem das Verfahren nach Anspruch 4 angewendet wird.

Es ist jedoch auch möglich, dass die Rotation der Ausgangsmagnetisierungsverteilung mittels eines GWP und eines folgenden KWP erfolgt, indem die Bloch-Gleichungen von der Ausgangsmagnetisierungsverteilung ausgehend vorwärts integriert und der Unterschied zwischen der um 180° rotierten Ausgangsmagnetisierungsverteilung und der so errechneten Magnetisierungsverteilung als eine zu erzeugende Zielmagnetisierungsverteilung für den KWP gesetzt wird.

Alternativ hierzu kann die Rotation der Ausgangsmagnetisierungsverteilung mittels eines ersten KWP, gefolgt von einem GWP, gefolgt von einem zweiten KWP erfolgen, indem die Bloch-Gleichungen von der um 180° rotierten Ausgangsmagnetisierungsverteilung ausgehend rückwärts integriert und der Unterschied zwischen der so errechneten Magnetisierungsverteilung und der Ausgangsmagnetisierungsverteilung als eine neue zu erzeugende Zielmagnetisierungsverteilung für den ersten KWP gesetzt wird, und indem die Bloch-Gleichungen für die Sequenz "erster KWP-GWP" von der Ausgangsmagnetisierungsverteilung ausgehend vorwärts integriert werden und der Unterschied zwischen der um 180° rotierten Ausgangsmagnetisierungsverteilung und der so errechneten Magnetisierungsverteilung als eine neue zu erzeugende Zielmagnetisierungsverteilung für den zweiten KWP gesetzt wird. Diese Variante des erfindungsgemäßen Verfahrens hat den Vorteil, dass die durch den GWP bedingten Abweichungen der Magnetisierungsverteilung des Ensembles von Kernspins von der Zielmagnetisierungsverteilung in zwei Schritten verringert werden können und so die Genauigkeit nochmals erhöht wird.

Bei einer weiteren Variante des erfindungsgemäßen Verfahrens wird die Spinmagnetisierung aus einer Ausgangsmagnetisierungsverteilung über eine Magnetisierungsverteilung, bei der die Magnetisierungsvektoren in Richtung der z-Achse ausgerichtet sind, in die Zielmagnetisierungsverteilung überführt mittels Anwendung eines GWP, gefolgt von einem KWP, der die Spinmagnetisierung in die Magnetisierungsverteilung bringt, bei der die Magnetisierungsvektoren in Richtung der z-Achse ausgerichtet sind, gefolgt von einer KWP-GWP-Sequenz, die die Zielmagnetisierungsverteilung herstellt. Diese Variante ist besonders vorteilhaft zur Refokussierung (=Spiegelung der Magnetisierungsverteilung an einer die z-Achse enthaltende Ebene) des Ensembles von Kernspins und zur Anwendung in "steady state" Sequenzen, wo beim Stand der Technik keine mehrdimensional räumlich selektive HF-Pulse anwendbar sind. Ein weiterer Vorteil ergibt sich aus einer zeitlichen Symmetrie des HF-Pulses, die das Verfahren gegenüber $B_0$-Offresonanzen unempfindlicher macht.

Besonders vorteilhaft ist es, wenn hierbei die beiden aufeinander folgenden KWP zu einem KWP zusammengefasst werden, der kürzer als die beiden aufeinander folgenden KWP ist. Eine Verkürzung der Dauer der gesamten HF-Puls-Sequenz wirkt sich vorteilhaft aus, indem die Empfindlichkeit gegenüber $B_0$-Offresonanzen sinkt und außerdem die Geschwindigkeit der Bildgebung insgesamt steigt.

Bei allen Verfahrensvarianten kann die Zielmagnetisierungsverteilung die an einer Ebene, die die z-Achse enthält, gespiegelte Magnetisierungsverteilung zur Ausgangsmagnetisierungsverteilung sein. Dies birgt den Vorteil, dass sich nach Anwendung des HF-Pulses eine vorangegangene Dephasierung des Ensembles von Kernspins wieder teilweise zurückentwickelt, was ein Spinecho erzeugt.

Bei einer weiteren Variante wird die gewünschte Magnetisierungsverteilung auf eine Ausgangsmagnetisierungsverteilung angewendet, die anders ist, als bei der Berechnung der Pulse angenommen wurde. Durch Anwendung des erfindungsgemäßen Verfahrens wird ein HF-Puls berechnet, dessen Anwendung auf ein Ensemble von Kernspins eine räumlich und frequenzselektive oder eine räumlich mehrdimensional selektive Rotation der Magnetisierungsvektoren dieses Ensembles definiert. Dabei gewährleisten die Eigenschaften der Rotationsoperation, dass auch die Vektoren einer anderen Magnetisierungsverteilung als der zur Berechnung angenommenen Ausgangsmagnetisierungsverteilung um den gleichen Winkel und die gleiche Achse rotiert wird, wie die angenommene Ausgangsmagnetisierungsverteilung. Diese Eigenschaft kann vorteilhaft ausgenutzt werden zur Anwendung der HF-Pulse zur Refokussierung einer unbekannten Ausgangsmagnetisierungsverteilung.

Das erfindungsgemäße Verfahren findet bevorzugt in der NMR-Tomographie und der NMR-Spektroskopie Anwendung.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung

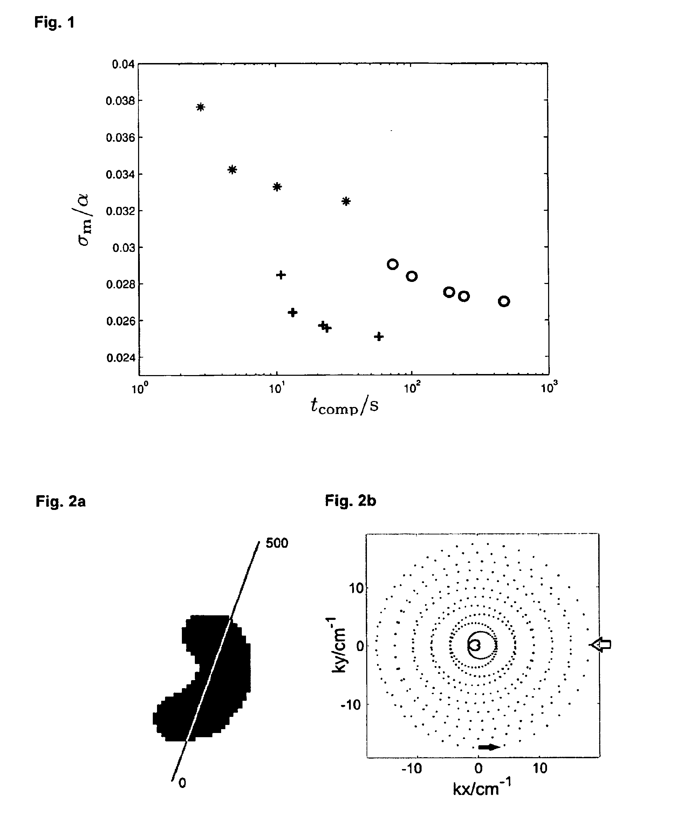

Fig. 1      zeigt einen Vergleich der Genauigkeit und des Zeitaufwands von Be- rechnungsmethoden für eine zweidimensional selektive Inversion (180° HF Puls). Die Sterne bezeichnen das Kleinwinkelverfahren "Transmit SENSE", die Kreise das Verfahren "Optimal Control" und das Kreuz das erfindungsgemäße Verfahren. Jedes Verfahren wur- de für mehrere typische Iterationstiefen bzw. Genauigkeitsvorgaben durchgeführt. Die mittlere quadratische Abweichung $\sigma_m/\alpha$ berech- net sich aus der Standardabweichung der Beträge der vektoriellen Abweichungen der Spinmagnetisierung von der Zielmagnetisie- rungsverteilung, geteilt durch den Flipwinkel. Die Berechnungsdauer $t_{comp}$/s in Sekunden bezieht sich auf einen aktuellen Personal Com- puter (Matlab und C im Einkernbetrieb auf intel core2 duo 2.66 GHz).

Fig. 2a      zeigt ein Zielmuster für einen Fall zweidimensional selektiver Anre- gung. Die Magnetisierungsprofile, die in den folgenden Figuren dar- gestellt werden, verlaufen entlang des eingezeichneten geraden Schnitts.

Fig. 2b      zeigt eine Illustration der zweiteiligen k-Raum-Trajektorie für einen Fall zweidimensional selektiver Anregung. Der offene Pfeil markiert die Übergangsstelle zwischen den beiden Teilpulsen in den unten beschriebenen Beispielen. Der ausgefüllte Pfeil zeigt die Rotations- richtung der Spirale bei fortschreitender Zeit an.

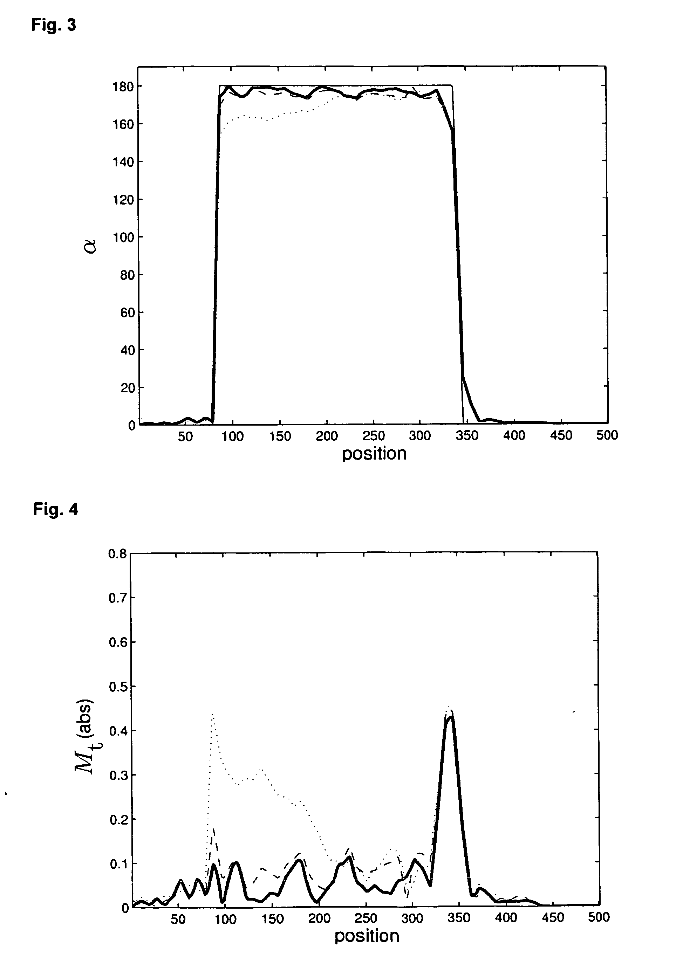

Fig. 3      zeigt eine Simulation der Winkelverteilung $\alpha$ der Magnetisierungs- verteilung bezogen auf die +z-Achse entlang des Schnitts in Fig. 2a. Die von den verschiedenen Verfahren erzeugten Winkelverteilungen sind gegenüber einer Zielwinkelverteilung (dünne durchgezogene Linie) dargestellt, wobei die gepunktete Linie das Verfahren "Trans- mit SENSE", die gestrichelte Linie das Verfahren "Optimal Cont- rol" und die dicke durchgezogene Linie das erfindungsgemäße Ver- fahren kennzeichnet.

Fig. 4      zeigt eine Simulation des Betrags der Transversalmagnetisierung $M_t$ entlang des Schnitts in Fig. 2a. Der Betrag der Transversalkom- ponente der Zielmagnetisierungsverteilung entspricht in diesem Fal- le der Null (Nullverteilung). Die gepunktete Linie kennzeichnet das Verfahren "Transmit SENSE", die gestrichelte Linie das Verfahren "Optimal Control" und die dicke durchgezogene Linie das erfin- dungsgemäße Verfahren.

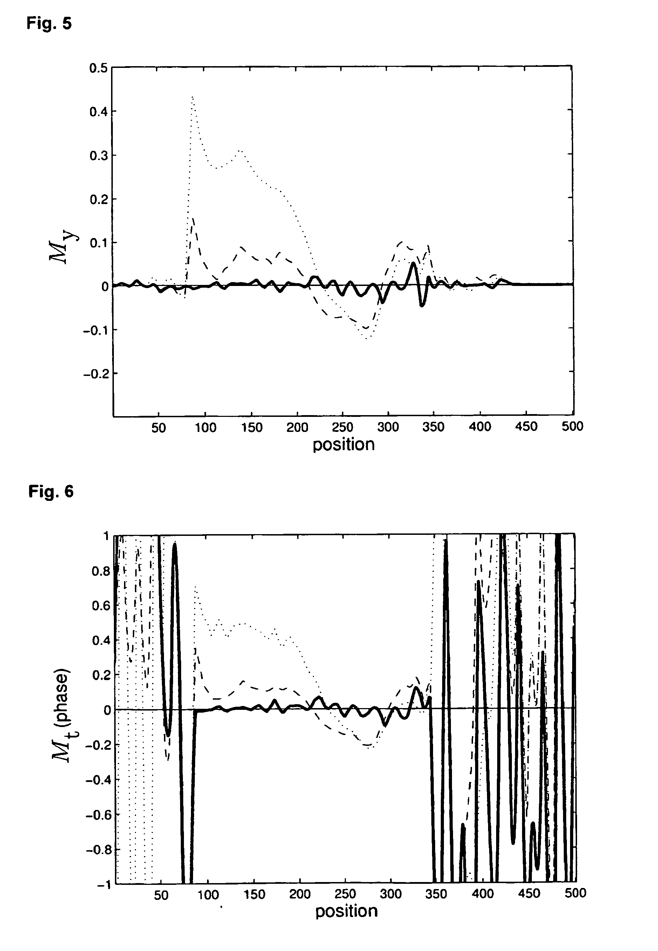

Fig. 5      zeigt eine Simulation der y-Komponente der Magnetisierung Myent- lang des Schnitts in Fig. 2a. Die y-Komponente der Zielmagnetisie- rungsverteilung entspricht in diesem Falle der Null, da eine Rotation um die x-Achse vorgegeben wurde. Die gepunktete Linie kennzeich- net das Verfahren "Transmit SENSE", die gestrichelte Linie das Ver- fahren "Optimal Control" und die dicke durchgezogene Linie das er- findungsgemäße Verfahren.

Fig. 6    zeigt eine Simulation der Phase der Transversalmagnetisierung $M_t$ entlang des Schnitts in Fig. 2a, bei einem 155° HF Puls. Die Phase der Transversalkomponente der Zielmagnetisierungsverteilung ent- spricht in diesem Falle der Null, da eine Rotation um die x-Achse vorgegeben wurde. Die gepunktete Linie kennzeichnet das Verfah- ren "Transmit SENSE", die gestrichelte Linie das Verfahren "Optimal Control" und die dicke durchgezogene Linie das erfindungsgemäße Verfahren. Außerhalb des angeregten Bereichs ist die Magnetisie- rung nahezu parallel zur z-Achse, daher ist die Phase nicht stabil de- finiert. Zum Vergleich der Methoden diene daher nur der Bereich zwischen Positionen 70 und 340.

Fig. 1 illustriert diese Aussagen anhand eines Beispiels für die Berechnung eines 180°-Pulses, für ein willkürliches Zielmuster (siehe Fig. 2a) auf einem räumlichen Gitter mit 64 x 64 Stützstellen. Die Form der k-Raum-Trajektorie zu diesem HF-Puls ist in Fig. 2b dargestellt, der Übersichtlichkeit wegen mit der halben Umdrehungszahl und mit einem Viertel der Zeitschritte. In diesem Beispiel wird der KWP auf der ersten Hälfte der Trajektorie ausgespielt [Spirale von innen k=(0,0) nach außen k=(18,0)/cm], während der GWP auf der zweiten Hälfte angewendet wird (k-Raum-Spirale von außen nach innen)

Das erfindungsgemäße Verfahren wird im Folgenden beispielhaft anhand der zweidimensional selektiven Inversion (Flipwinkel=180°) eines Zielmusters (Fig. 2a) beschrieben. Hierbei soll die Rotation der Spinmagnetisierung so erfolgen, dass zu Ende des Pulses an jedem Punkt innerhalb des Zielmusters eine Gesamtrotation um 180° um die x- Achse erfolgt ist, während außerhalb des Zielmusters keine Gesamtrotation stattgefunden hat. In diesem Beispiel erfolgt zunächst ein GWP mit einem folgenden KWP.

Der erste Schritt besteht aus der Lösung von Gleichung (2) nach $I_l(t)$, wobei der Betrag von $M_t(\mathbf{r})$ gleich der Winkelverteilung der Zielmagnetisierungsverteilung (mit einer erniedrigten Amplitude von 10° innerhalb des Zielmusters) gesetzt wird und die Phase von $M_t(\mathbf{r})$ auf Null, wodurch eine effektive Rotation um die x-Achse vorgegeben wird. (Bemerkung: In der Kleinwinkelnäherung ist jede "Rotation" der Magnetisierung durch die Angabe zweier Werte festgelegt, nicht wie im allgemeinen Fall durch drei. Eine Rotation um die z-Achse kann nicht durch die $B_1$-Felder erzeugt werden). Für k(r) wird die erste Hälfte der Trajektorie in Fig. 2b angesetzt und gemessene Sendeprofile $S_l$ verwendet. Die resul- tierenden HF-Pulsformen $I_l(t)$ werden nun um den Faktor 18 erhöht, und diese Pulsformen (der GWP) werden nun zusammen mit den gleichen $S_l$ und k(r) für die Vorwärtslösung von Gleichung (1) verwendet. Das sich ergebende $\mathbf{M}(T/2, r)$ wird um die ortsabhängige Phase bereinigt, die von der verbleibenden k-Raum-Trajektorie noch erzeugt würde. Wird nun die vektorielle Differenz Zielmagnetisierungsverteilung - $\mathbf{M}(T/2, \mathbf{r})$ gebildet, erhält man eine nicht-verschwindende Magnetisierungsverteilung, da die Kleinwinkelnäherung für 180° nicht gültig ist. Diese Differenzverteilung lässt sich nun auf dem zweiten Teil der k-Raum-Trajektorie näher an die gewünschte Nullverteilung heranführen, indem man die Differenzverteilung wiederum als neue Zielmagnetisierungsverteilung für Gleichung (2) vorgibt. Für die k-Raum- Trajektorie kommt nun die zweite, nach innen laufende, Hälfte zum Einsatz. Da die Magnetisierung innerhalb des Zielmusters zwar schon einen großen Flipwinkel aber dennoch nur wenig transversale Magnetisierung aufweist, ist Gleichung (2) gleichzeitig für die Magnetisierung, die kleine Winkel zur z-Achse aufweist, und für die grob invertierte Magnetisierung gültig. Diese neue, nicht-triviale Erweiterung des Gültigkeitsbereichs von Gleichung (2) vom Kleinwinkelbereich auf den Bereich kleiner transversaler Magnetisierung (STM = "small transverse magnetization") ermöglicht eine schnelle Lösung des verbleibenden Problems. Man erhält aus dieser Lösung den KWP und daraus den gesamten HF-Puls als Verkettung des GWP und des KWP. Die resultierende Winkelverteilung der Magnetisierung nach Anwendung dieses HF-Pulses nach erfindungsgemäßem Verfahren ist in Fig. 3 dargestellt, im Vergleich mit dem reinen Kleinwinkelverfahren Transmit SENSE und der Optimal Control. Alle Verfahren wurden mit denselben Sendeprofilen und auf derselben k-Raum-Trajektorie durchgeführt. Es ist gut zu erkennen, dass das erfindungsgemäße Verfahren ein besseres Resultat als das Verfahren "Transmit SENSE" bewirkt, und ein vergleichbar gutes (tendenziell besseres) Resultat wie "Optimal Control". In Fig. 4 ist entsprechend die Transversalmagnetisierung im Vergleich dargestellt. Auch hier sind die Ergebnisse des erfindungsgemäßen Verfahrens denen des Kleinwinkelverfahrens überlegen und vergleichbar gut wie "Optimal Control". Eine deutliche Transversalmagnetisierung am Rand des Zielmusters ist bei allen Verfahren zu beobachten und nicht immer zu vermeiden, da in einem kurzen Abstand der Flipwinkel von 0 auf 180° variiert und daher auch 90° durchlaufen muss. Fig. 5 zeigt am deutlichsten die Abweichungen des Kleinwinkelverfahrens von der Zielmagnetisierungsverteilung. Die Vorgabe, eine Rotation um die x-Achse, wird am besten vom erfindungsgemäßen Verfahren geleistet, das Kleinwinkelverfahren erzeugt hingegen massiv y-Magnetisierung auch innerhalb des Zielmusters.

Ein weiteres Beispiel ist gegeben für den Fall eines selektiven HF-Pulses mit einem Flipwinkel von 155° um die x-Achse. Hier ist die Anwendung der STM-Näherung in einem zweiten Schritt nicht möglich, da offensichtlich die Zielmagnetisierungsverteilung außerhalb des Gültigkeitsbereiches der STM-Näherung liegt. Daher wird hier eine Sequenz KWP-GWP angewendet, die erfindungsgemäß folgendermaßen erzeugt wird. Zunächst wird der GWP erzeugt durch Lösung von Gleichung (2), wobei der Betrag von $M_t(\mathbf{r})$ gleich der Zielmagnetisierungsverteilung mit Amplitude 10° gesetzt, die Phase von $M_t(\mathbf{r})$ auf Null gesetzt und für $\mathbf{k}(\mathbf{r})$ die *zweite* Hälfte der Trajektorie in Fig. 2b angesetzt wird. Mit den resultierenden HF-Pulsformen $I_l(t)$, um den Faktor 15,5 erhöht (dem GWP), wird nun Gleichung (1) rückwärts von T bis $T/2$ integriert, mit der vektoriellen Zielmagnetisierungsverteilung als Startwert. Wäre Gleichung (2) im Bereich großer Winkel gültig, würde man die Gleichgewichtsverteilung (Magnetisierungsverteilung, bei der die Vektoren der Spinmagnetisierung an allen Stützstellen in Richtung der z-Achse ausgerichtet sind) als $\mathbf{M}(T/2, \mathbf{r})$ erhalten. Dies ist jedoch nicht der Fall und $\mathbf{M}(T/2, \mathbf{r})$ enthält noch immer Abweichungen von der z-Magnetisierung. Diese Abweichungen dienen nun als neue Zielmagnetisierungsverteilung für den KWP auf der ersten Hälfte der k-Raum-Trajektorie. Wendet man den KWP und den GWP (vorwärts) auf der gesamten k-Raum-Trajektorie an, erhält man eine Magnetisierungsverteilung, aus der die gleichen Schlussfolgerungen für die verschiedenen Verfahren gezogen werden können, wie für den Fall 180°. Für den Fall 155° kann außerdem noch die Phase der Transversalmagnetisierung verglichen werden, wie in Fig. 6 dargestellt. Es ist gut zu erkennen, dass die Vorgabe, eine Rotation um die x-Achse, am besten vom erfindungsgemäßen Verfahren geleistet wird, und das Kleinwinkelverfahren größere Phasenabweichungen innerhalb des Zielmusters hervorruft.

Im Vergleich zum ersten Beispiel, bei dem ein GWP gefolgt von einem KWP in STM-Näherung angewendet wurde und das nur für Flipwinkel nahe bei 0° und 180° gültig ist, können mit dieser Variante des Verfahrens (KWP gefolgt von einem GWP) beliebige Zielmagnetisierungsverteilungen erzeugt werden.

**Referenzen:**

[1] P. Ullmann et al., MRM 54, 994-1001 (2005).

[2] S. Conolly et al., Proceedings of the 5th Annual Meeting of SMRM, Montreal, Canada, 1456-1457 (1986).

[3] D. Xu et al., MRM 59, 547-560 (2008).

[4] U. Katscher et al., MRM 49, 144-150 (2003).

[5] Y. Zhu, MRM 51, 775-784 (2004).

**Patentansprüche**

1. Magnetresonanz-Verfahren zur Anwendung eines Hochfrequenzpulses in einem Probenvolumen für eine räumlich und frequenzselektive oder mehrdimensional räumlich selektive Anregung eines Ensembles von Kemspins mit einer Ausgangsmagnetisierungsverteilung in einem entlang einer z-Achse ausgerichteten Hauptmagnetfeld, wobei eine Spinmagnetisierung mit einer vorgegebenen Zielmagnetisierungsverteilung erzeugt wird, und
   für eine entsprechend selektive Refokussierung der Spinmagnetisierung, wobei der Hochfrequenzpuls aus einer Sequenz mehrerer Teilpulse zusammengesetzt ist,
   **dadurch gekennzeichnet,**
   **dass** die Sequenz beinhaltet:

   - einen oder mehrere Großwinkel-HF-Pulse =GWP, jeweils mit einem Flipwinkel $\gtrsim 15°$ im Probenvolumen, welche durch Erhöhung der Amplitude von solchen HF-Pulsen erzeugt werden, die in Kleinwinkelnäherung berechnet wurden, wobei die GWP eine grobe Magnetisierungsverteilung erzeugen, die eine gewünschte Magnetisierungsverteilungs-änderung mit einer mittleren Abweichung $\leq 15°$ im Probenvolumen annähert, wobei die tatsächliche Auswirkung der GWP auf die Verteilung der Spinmagnetisierung vor der Anwendung des Hochfrequenzpulses durch Vorwärtslösung der Bloch-Gleichungen ohne Kleinwinkelnäherung berechnet wird, und
   - einen oder mehrere Kleinwinkel-HF-Pulse =KWP jeweils mit einem Füpwinkei $\leq 15°$ im Probenvolumen, wobei der Flipwinkel an mindestens einem Ort im Probenvolumen $> 0°$ ist, wobei die KWP eine Verringerung des Unterschieds zwischen der Zielmagnetisierungsverteilung und der durch die GWP bedingten groben Magnetisierungsverteilung bewirkten, und die KWP durch Lösung der Bloch'schen Gleichungen in der Kleinwinkelnäherung berechnet werden, d.h. mit Winkel der Magnetisierungsvektoren des Ensembles von Krnspins $\leq 15°$ zur positiven oder negativen z-Achse.

2. Verfahren nach Anspruch 1, **dadurch gekennzeichnet, dass** die Spinmagnetisierung aus einer Ausgangsmagnetisierungsverteilung, bei der die Magnetisierungsvektoren in Richtung der z-Achse ausgerichtet sind, in die Zielmagnetisierungsverteilung mittels eines KWP und eines folgenden GWP überführt wird, indem die Bloch-Gleichungen von der Zelmagnetisierungsverteilung ausgehend rückwärts integriert und der Unterschied zwischen der so errechneten Magnetisierungsverteilung und der Ausgangsmagnetisierungsverteilung als eine neue zu erzeugende Zielmagnetisierungsverteilung für den KWP gesetzt wird.

3. Verfahren nach Anspruch 1, **dadurch gekennzeichnet, dass** die Spinmagnetisierung von einer Ausgangsmagnetisierungsverteilung in eine Zielmagnetisierungsverteilung, bei der die Magnetisierungsvektoren in Richtung der z-Achse ausgerichtet sind, mittels eines GWP und eines folgenden KWP überführt wird, indem die Bloch-Gleichungen von der Ausgangsmagnetisierungsverteilung ausgehend vorwärts integriert werden und der Unterschied zwischen der Zielmagnetisierungsverteilung und der so errechneten Magnetisierungsverteilung als eine neue zu erzeugende Zielmagnetisierungsverteilung für den KWP gesetzt wird.

4. Verfahren nach Anspruch 1, **dadurch gekennzeichnet, dass** die Spinmagnetisierung selektiv um 180° aus einer Ausgangsmagnetisierungsverteilung, bei der die Magnetisierungsvektoren in Richtung der z-Achse ausgerichtet sind, rotiert wird.

5. Verfahren nach Anspruch 4, **dadurch gekennzeichnet, dass** die in Anspruch 4 definierte Rotation der Ausgangsmagnetisierungsverteilung mittels eines KWP und eines folgenden GWP erfolgt, indem das Verfahren nach Anspruch 4 angewendet wird.

6. Verfahren nach Anspruch 4, **dadurch gekennzeichnet, dass** die in Anspruch 4 definierte Rotation der Ausgangsmagnetisierungsverteilung mittels eines GWP und eines folgenden KWP erfolgt, indem die Bloch-Gleichungen von der Ausgangsmagnetisierungsverteilung ausgehend vorwärts integriert und der Unterschied zwischen der um 180° rotierten Ausgangsmagnetisierungsverteilung und der so errechneten Magnetisierungsverteilung als eine zu erzeugende Zielmagnetisierungsverteilung für den KWP gesetzt wird.

7. Verfahren nach Anspruch 4, **dadurch gekennzeichnet, dass** die Rotation der Ausgangsmagnetisierungsverteilung mittels eines ersten KWP, gefolgt von einem GWP, gefolgt von einem zweiten KWP erfolgt, indem die Bloch-Gleichungen von der um 180° rotierten Ausgangsmagnetisierungsverteilung ausgehend rückwärts integriert und der Unterschied zwischen der so errechneten Magnetisierungsverteilung und der Ausgangsmagnetisierungsverteilung als eine neue zu erzeugende Zielmagnetisierungsverteilung für den ersten KWP gesetzt wird, und indem die Bloch-Gleichungen für die Sequenz "erster KWP-GWP" von der Ausgangsmagnetisierungsverteilung ausgehend vorwärts integriert werden und der Unterschied zwischen der um 180° rotierten Ausgangsmagnetisierungsverteilung und der so errechneten Magnetisierungsverteilung als eine neue zu erzeugende Zielmagnetisierungsverteilung für den zweiten KWP gesetzt wird.

8. Verfahren nach Anspruch 1, **dadurch gekennzeichnet, dass** die Spinmagnetisierung aus einer Ausgangsmagnetisierungsverteilung über eine Magnetisierungsverteilung, bei der die Magnetisierungsvektoren in Richtung der z-Achse ausgerichtet sind, in die Zielmagnetisierungsverteilung überführt wird mittels Anwendung eines GWP, gefolgt von einem KWP, der die Spinmagnetisierung in die Magnetisierungsverteilung bringt, bei der die Magnetisierungsvektoren in Richtung der z-Achse ausgerichtet sind, gefolgt von einer KWP-GWP-Sequenz, die die Zielmagnetisierungsverteilung herstellt.

9. Verfahren nach Anspruch 8, **dadurch gekennzeichnet, dass** die beiden aufeinanderfolgenden KWP zu einem KWP zusammengefasst werden, der kürzer als die beiden aufeinanderfolgenden KWP ist.

10. Verfahren nach Anspruch 8 oder 9, **dadurch gekennzeichnet, dass** die Ausgangsmagnetisierungsverteilung an einer Ebene, die die z-Achse enthält, gespiegelt wird und als Zielmagnetisierungsverteilung gesetzt wird.

## Claims

1. A magnetic resonance method for applying a radio frequency pulse in a sample volume for spatially selective and frequency-selective or multi-dimensionally spatially selective excitation of an ensemble of nuclear spins with an initial distribution of magnetization in a main magnetic field which is aligned along a z-axis, wherein spin magnetization is generated with a predetermined target distribution of magnetization, and
for corresponding selective refocusing of spin magnetization, wherein the radio frequency pulse is composed from a sequence of several partial pulses,
**characterized in that**
the sequence contains:

- one or more large angle RF pulses = LAP, each having a flip angle $\geq 15°$ in the sample volume and being generated by increasing the amplitude of such RF pulses which were calculated through small angle approximation, wherein the LAP generate a gross distribution of magnetization approximating a desired change of the distribution of magnetization with a mean deviation $\leq 15°$ in the sample volume, wherein the actual effect of the LAP onto the distribution of the spin magnetization is calculated prior to application of the radio frequency pulse by forward integration of the Bloch equations without small angle approximation, and
- one or more small angle RF pulses = SAP, each having a flip angle $\leq 15°$ in the sample volume, wherein the flip angle $>0°$ at least at one location in the sample volume, wherein the SAP reduce the difference between the target distribution of magnetization and the gross distribution of magnetization caused by the LAP, and the SAP are calculated through integration of the Bloch equations in small angle approximation, i.e. with angles of magnetization vectors of the ensemble of nuclear spins $\leq 15°$ with respect to the positive or negative z-axis.

2. The method according to claim 1, **characterized in that** the spin - magnetization is converted from an initial distribution of magnetization, where magnetization vectors are aligned along the z-axis, into the target distribution of magnetization by means of an SAP and a subsequent LAP by backward integration of the Bloch equations, starting from the target distribution of magnetization, and by setting a difference between the thereby calculated distribution of magnetization and the initial distribution of magnetization as a new target distribution of magnetization to be generated for the SAP.

3. The method according to claim 1, **characterized in that** the spin magnetization is converted from an initial distribution of magnetization into a target distribution of magnetization, where magnetization vectors are aligned along the z-axis by means of an LAP and a subsequent SAP by forward integration of the Bloch equations, starting from the initial distribution of magnetization, and by setting a difference between the target distribution of magnetization and the thereby calculated distribution of magnetization as a new target distribution of magnetization to be generated for the SAP.

4. The method according to claim 1, **characterized in that** the spin magnetization is selectively rotated by 180° from an initial distribution of magnetization, where the magnetization vectors are aligned along the z-axis.

5. The method according to claim 4, **characterized in that** rotation of the initial distribution of magnetization, defined in claim 4, is performed by means of an SAP and a subsequent LAP by applying the method according to claim 4.

6. The method according to claim 4, **characterized in that** rotation of the initial distribution of magnetization, defined in claim 4, is performed by means of an LAP and a subsequent SAP using forward integration of the Bloch equations, starting from the initial distribution of magnetization, and setting a difference between the initial distribution of magnetization rotated by 180° and the thereby calculated distribution of magnetization as a target distribution of magnetization to be generated for the SAP.

7. The method according to claim 4, **characterized in that** the initial distribution of magnetization is rotated by means of a first SAP, followed by an LAP, followed by a second SAP using backward integration of the Bloch equations, starting from the initial distribution of magnetization rotated by 180°, and setting a difference between the thereby calculated distribution of magnetization and the initial distribution of magnetization as a new target distribution of magnetization to be generated for the first SAP, and using forward integration of the Bloch equations for the sequence "first SAP-LAP", starting from the initial distribution of magnetization, and by setting a difference between the initial distribution of magnetization rotated by 180° and the thereby calculated distribution of magnetization as a new target distribution of magnetization to be generated for the second SAP.

8. The method according to claim 1, **characterized in that** the spin magnetization is converted from an initial distribution of magnetization, via a distribution of magnetization, where the magnetization vectors are aligned along the z-axis, into the target distribution of magnetization using an LAP, followed by an SAP, to shift the spin magnetization to a distribution of magnetization, where the magnetization vectors are aligned along the z-axis, followed by an SAP-LAP sequence which generates the target distribution of magnetization.

9. The method according to claim 8, **characterized in that** the two subsequent SAP are combined to form one SAP which is shorter than the two subsequent SAP.

10. The method according to claim 8 or 9, **characterized in that** the initial distribution of magnetization is mirrored in a plane containing the z-axis and is set as target distribution of magnetization.

## Revendications

1. Procédé de résonance magnétique pour l'application d'une impulsion à haute fréquence dans un volume d'échantillon pour une excitation spatialement sélective et sélective en fréquence ou spatialement sélective multidimensionnelle d'un ensemble de spins de noyaux avec une distribution d'aimantation de départ dans un champ magnétique principal orienté le long d'un axe z, une aimantation de spin étant produite avec une distribution d'aimantation cible prédéfinie, et
pour une refocalisation sélective correspondante de l'aimantation de spin, l'impulsion à haute fréquence étant composée d'une séquence de plusieurs impulsions partielles,
**caractérisé en ce**
**que** la séquence comprend :

- une ou plusieurs impulsions HF de grand angle = GWP, chaque fois avec un angle de bascule $\geq$ 15° dans le volume d'échantillon, lesquelles sont produites par augmentation de l'amplitude des impulsions HF qui ont été calculées avec approximation des petits angles, les GWP produisant une distribution d'aimantation grossière qui approche une modification de distribution d'aimantation souhaitée avec un écart moyen $\leq$ 15° dans le volume d'échantillon, l'effet réel des GWP sur la distribution de l'aimantation de spin avant application de l'impulsion à haute fréquence étant calculé par résolution directe des équations de Bloch sans approximation des petits angles, et
- une ou plusieurs impulsions HF de petit angle = KWP, chaque fois avec un angle de bascule $\leq$ 15° dans le volume d'échantillon, l'angle de bascule étant > 0° en au moins un endroit dans le volume d'échantillon, les KWP produisant une diminution de la différence entre la distribution d'aimantation cible et la distribution d'aimantation grossière causée par les GWP, et les KWP étant calculées par résolution des équations de Bloch dans l'approximation des petits angles, c'est-à-dire avec des angles des vecteurs d'aimantation de l'ensemble de spins de noyaux $\leq$ 15° par rapport à l'axe z positif ou négatif.

2. Procédé selon la revendication 1, **caractérisé en ce que** l'on fait passer l'aimantation de spin d'une distribution d'aimantation de départ, dans laquelle les vecteurs d'aimantation sont orientés dans la direction de l'axe z, à la distribution d'aimantation cible au moyen d'une KWP et d'une GWP suivante, les équations de Bloch étant intégrées à rebours en partant de la distribution d'aimantation cible et la différence entre la distribution d'aimantation ainsi calculée et la distribution d'aimantation de départ étant posée comme une nouvelle distribution d'aimantation cible à produire pour la KWP.

3. Procédé selon la revendication 1, **caractérisé en ce que** l'on fait passer l'aimantation de spin d'une distribution d'aimantation de départ à une distribution d'aimantation cible, dans laquelle les vecteurs d'aimantation sont orientés dans la direction de l'axe z, au moyen d'une GWP et d'une KWP suivante, les équations de Bloch étant intégrées en avant en partant de la distribution d'aimantation de départ et la différence entre la distribution d'aimantation cible et la distribution d'aimantation ainsi calculée étant posée comme une nouvelle distribution d'aimantation cible à produire pour la KWP.

4. Procédé selon la revendication 1, **caractérisé en ce que** l'on fait tourner l'aimantation de spin sélectivement de 180° en partant d'une distribution d'aimantation de départ dans laquelle les vecteurs d'aimantation sont orientés dans la direction de l'axe z.

5. Procédé selon la revendication 4, **caractérisé en ce que** la rotation de la distribution d'aimantation de départ définie dans la revendication 4 est effectuée au moyen d'une KWP et d'une GWP suivante en utilisant le procédé selon la revendication 4.

6. Procédé selon la revendication 4, **caractérisé en ce que** la rotation de la distribution d'aimantation de départ définie dans la revendication 4 est effectuée au moyen d'une GWP et d'une KWP suivante en intégrant en avant les équations de Bloch en partant de la distribution d'aimantation de départ et en posant la différence entre la distribution d'aimantation de départ tournée de 180° et la distribution d'aimantation ainsi calculée comme une distribution d'aimantation cible à produire pour la KWP.

**7.** Procédé selon la revendication 4, **caractérisé en ce que** la rotation de la distribution d'aimantation de départ définie est effectuée au moyen d'une première KWP suivie d'une GWP, suivie d'une deuxième KWP, en intégrant à rebours les équations de Bloch en partant de la distribution d'aimantation de départ tournée de 180° et en posant la différence entre la distribution d'aimantation ainsi calculée et la distribution d'aimantation de départ comme une nouvelle distribution d'aimantation cible à produire pour la première KWP, et en intégrant en avant les équations de Bloch pour la séquence « première KWP-GWP » en partant de la distribution d'aimantation de départ et en posant la différence entre la distribution d'aimantation de départ tournée de 180° et la distribution d'aimantation ainsi calculée comme une nouvelle distribution d'aimantation cible à produire pour la deuxième KWP.

**8.** Procédé selon la revendication 1, **caractérisé en ce que** l'on fait passer l'aimantation de spin d'une distribution d'aimantation de départ, en passant par une distribution d'aimantation dans laquelle les vecteurs d'aimantation sont orientés dans la direction de l'axe z, à la distribution d'aimantation cible en appliquant une GWP, suivie d'une KWP qui met l'aimantation de spin dans la distribution d'aimantation dans laquelle les vecteurs d'aimantation sont orientés dans la direction de l'axe z, suivie d'une séquence KWP-GWP qui produit la distribution d'aimantation cible.

**9.** Procédé selon la revendication 8, **caractérisé en ce que** les deux KWP successives sont réunies en une KWP qui est plus courte que les deux KWP successives.

**10.** Procédé selon la revendication 8 ou 9, **caractérisé en ce que** la distribution d'aimantation de départ est réfléchie sur un plan qui contient l'axe z et posée comme distribution d'aimantation cible.

**Fig. 1**

**Fig. 2a**

**Fig. 2b**

**Fig. 3**

**Fig. 4**

**Fig. 5**

**Fig. 6**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **P. ULLMANN et al.** *MRM,* 2005, vol. 54, 994-1001
- **S. CONOLLY et al.** *Proceedings of the 5th Annual Meeting of SMRM,* 1986, 1456-1457
- **D. XU et al.** *MRM,* 2008, vol. 59, 547-560
- **U. KATSCHER et al.** *MRM,* 2003, vol. 49, 144-150
- **Y. ZHU.** *MRM,* 2004, vol. 51, 775-784